# EUROPEAN PATENT APPLICATION

(11) **EP 2 166 558 A2**
(43) Date of publication of application: **24.03.2010**
(21) Application number: 09011923.1
(22) Date of filing: 18.09.2009
(51) Int. Cl.: H01J 37/18, G01N 1/32, H01J 37/302

(54) **Electron microscope, pressure control method and recording medium**

(30) Priority: 19.09.2008 JP 2008241569
(71) Applicant: HORIBA, LTD., Minami-ku Kyoto 601-8510 (JP)
(72) Inventor: Iwasaki, Shunsuke, Kyoto 601-8510 (JP); Hirano, Akihiro, Kyoto 601-8510 (JP); Chapon, Patric, 91165 Longjumeau Cedex (FR)
(74) Representative: Müller - Hoffmann & Partner

(57) **Abstract**

A specimen-exchange chamber (50) is provided adjacent to an observation chamber (70). The specimen-exchange chamber (50) is provided therein with a glow-discharge digging unit (2), and a specimen is transferred into the specimen-exchange chamber (50). When the specimen is transferred into the specimen-exchange chamber (50), pressures in the specimen-exchange chamber (50) and the glow-discharge digging unit (2) are controlled to a first pressure by an exchange chamber pump (63) which exhausts air in the specimen-exchange chamber (50), and by a first pump (61) and a second pump (62) which exhaust air in the glow-discharge digging unit. After the pressures are reduced to the first pressure and the specimen is digged by the glow-discharge digging unit (2), a pressure in the specimen-exchange chamber (50) is controlled to a second pressure which is lower than the first pressure. Thereafter, a transfer mechanism (650) transfers the specimen into the observation chamber (70).

## Description

### FIELD

The present invention relates to an electron microscope for observing a specimen in an observation chamber, a pressure control method of the electron microscope, and a recording medium in which a program for causing a computer connected to the electron microscope to function is stored.

### BACKGROUND

In recent years, an electron microscope is widely used for observing a specimen in an observation chamber in a nano region by irradiating the specimen with electron beams. When observing a specimen made of, e.g., iron, steel, ceramics, or semiconductor using the electron microscope, it is necessary to expose texture on a surface of the specimen as a pretreatment.
A glow-discharge digging apparatus is used for this pretreatment to dig surfaces of specimens (see, for example, Japanese Laid-open Patent Publication No. 2008-051779).

In the conventional technique, however, after a specimen is digged by the glow-discharge digging apparatus, the specimen is put in a specimen-exchange chamber of the electron microscope and the specimen is observed in the observation chamber. Therefore, there is a problem that the specimen comes into contact with the atmosphere. Because of this, there is a problem that the specimen surface is contaminated by the atmosphere before the specimen is observed using the electron microscope. Patent Document 1 does not disclose any means for solving the problem.

### SUMMARY

The present invention has been accomplished in view of the above circumstances, and it is an object of the invention to provide an electron microscope having a glow-discharge digging unit in a specimen-exchange chamber thereof, with which it is possible to observe a specimen after a pretreatment by a glow-discharge digging unit without contaminating the specimen by executing appropriate pressure control. It is also an object of the invention to provide a pressure control method of the electron microscope, and a recording medium in which a program that causes a computer connected to the electron microscope to function is stored.

An electron microscope disclosed in the present application for observing a specimen in an observation chamber includes a specimen-exchange chamber which is provided adjacent to the observation chamber and which is provided therein with a glow-discharge digging unit, an exchange chamber exhausting unit for exhausting air in the specimen-exchange chamber, an digging unit exhausting unit for exhausting air in the glow-discharge digging unit, first control means for controlling pressures in the specimen-exchange chamber and the glow-discharge digging unit to a first pressure when the specimen is transferred into the specimen-exchange chamber by the exchange chamber exhausting unit and the digging unit exhausting unit, second control means for controlling a pressure in the specimen-exchange chamber to a second pressure which is lower than the first pressure by the exchange chamber exhausting unit after the pressures are controlled to the first pressure by the first control means and the specimen is digged by the glow-discharge digging unit, and transfer means for transferring the specimen to the observation chamber after the pressure is controlled to the second pressure by the second control means.

In the electron microscope disclosed in the present application, the glow-discharge digging unit is provided at a lower portion in the specimen-exchange chamber, and the electron microscope further includes turn-over means for turning over the specimen when the specimen is transferred by the transfer means.

The electron microscope disclosed in the present application further includes receiving means for receiving re-digging information indicating that a digging operation is again carried out by the glow-discharge digging unit after the specimen is observed in the observation chamber, third control means for controlling a pressure in the specimen-exchange chamber to the second pressure by the exchange chamber exhausting unit when the re-digging information is received by the receiving means, and fourth control means for controlling the pressures in the specimen-exchange chamber and the glow-discharge digging unit to the first pressure by the exchange chamber exhausting unit and the digging unit exhausting unit after the third control means controls the pressure to the second pressure and the transfer means transfers the specimen from the observation chamber to the specimen-exchange chamber.

A pressure control method disclosed in the present application includes a step of transferring the specimen into a specimen-exchange chamber which is provided adjacent to the observation chamber and which is provided therein with a glow-discharge digging unit, a first control step of controlling pressures in the specimen-exchange chamber and the glow-discharge digging unit to a first pressure by an exchange chamber exhausting unit which exhausts air in the specimen-exchange chamber and by a digging unit exhausting unit which exhausts air in the glow-discharge digging unit when the specimen is transferred into the specimen-exchange chamber, a second control step of controlling a pressure in the specimen-exchange chamber to a second pressure which is lower than the first pressure by the exchange chamber exhausting unit after the pressures are controlled to the first pressure in the first control step and the specimen is digged by the glow-discharge digging unit, and a transfer step of transferring the specimen into the observation chamber by the transfer means after the pressure is controlled to the second pressure in the second control step.

A recording medium disclosed in the present application is used for a computer connected to an electron microscope for observing a specimen in an observation chamber. A specimen-exchange chamber having therein a glow-discharge digging unit is provided adjacent the observation chamber. The computer is made to execute a first control step of controlling pressures in the specimen-exchange chamber and the glow-discharge digging unit to a first pressure by an exchange chamber exhausting unit which exhausts air in the specimen-exchange chamber and by a digging unit exhausting unit which exhausts air in the glow-discharge digging unit when the specimen is transferred into the specimen-exchange chamber, a second control step of controlling a pressure in the specimen-exchange chamber to a second pressure which is lower than the first pressure by the exchange chamber exhausting unit after the pressures are controlled to the first pressure in the first control step and the specimen is digged by the glow-discharge digging unit, and an output step of outputting an instruction for causing the transfer means to transfer the specimen into the observation chamber after the pressure is controlled to the second pressure in the second control step.

According to the electron microscope disclosed in the present application, the specimen-exchange chamber is provided adjacent to the observation chamber, and is provided therein with the glow-discharge digging unit. The specimen is transferred into the specimen-exchange chamber. When the specimen is transferred into the specimen-exchange chamber, the first control means controls pressures in the specimen-exchange chamber and the glow-discharge digging unit by the exchange chamber exhausting unit which exhausts air in the specimen-exchange chamber and by the digging unit exhausting unit which exhausts air in the glow-discharge digging unit. The second control means controls pressures to the first pressure. After the glow-discharge digging unit digs the specimen, the second control means controls a pressure in the specimen-exchange chamber to a second pressure which is lower than the first pressure. Thereafter, the transfer means transfers the specimen to the observation chamber.

According to the electron microscope disclosed in the present application, the glow-discharge digging unit is provided at a lower portion of the specimen-exchange chamber. The turn-over means turns over the specimen when the transfer means transfers the specimen.

According to the electron microscope disclosed in the present application, after the specimen is observed in the observation chamber, re-digging information indicating that the specimen is again digged by the glow-discharge digging unit is received. When the third control means receives the re-digging information, the third control means controls a pressure in the specimen-exchange chamber to the second pressure. The fourth control means controls a pressure to the second pressure. When the specimen is transferred from the observation chamber to the specimen-exchange chamber, pressures in the specimen-exchange chamber and the glow-discharge digging unit are controlled to the first pressure by the exchange chamber exhausting unit and the digging unit exhausting unit.

According to an aspect of the electron microscope, after a pressure is reduced by the first control means to the first pressure which is lower than the atmospheric pressure, the digging operation is carried out. Therefore, the glow-discharge state in the glow-discharge digging unit can be stabilized. After the pressure is reduced to the second pressure which is lower than the first pressure, the specimen after the pretreatment is transferred to the observation chamber. Therefore, a foreign substance generated with the glow-discharge processing can be removed, and it is possible to perform observation swiftly in the electron microscope where a high degree of vacuum is required.
The object and advantages of the invention will be realized and attained by the elements and combinations particularly pointed out in the claims. It is to be understood that both the foregoing general description and the following detailed description are exemplary and explanatory and are not restrictive of the embodiment, as claimed.

### BRIEF DESCRIPTION OF DRAWINGS

FIG. 1 is a schematic diagram showing a structure of an electron microscope;
FIG. 2 is a block diagram showing a structure of each piece of hardware including a control unit;
FIG. 3 is an explanatory diagram showing a structure and a state transition of the electron microscope;
FIG. 4 is an explanatory diagram showing the structure and the state transition of the electron microscope;
FIG. 5 is an explanatory diagram showing the structure and the state transition of the electron microscope;
FIG. 6 is an explanatory diagram showing the structure and the state transition of the electron microscope;
FIG. 7 is an explanatory diagram showing the structure and the state transition of the electron microscope;
FIGS. 8A to 8C are flowcharts showing a pressure control procedure;
FIG. 9 is a block diagram showing a structure of each piece of hardware including a control unit according to a second embodiment;
FIG. 10 is an explanatory diagram showing an image of a selection screen;
FIG. 11 is an explanatory diagram showing an image of a condition entry screen;
FIGS. 12A to 12D are flowcharts showing a procedure of a re-digging process; and
FIG. 13 is a block diagram showing a structure of each piece of hardware including a control unit according to a third embodiment.

### DESCRIPTION OF EMBODIMENTS

### First Embodiment

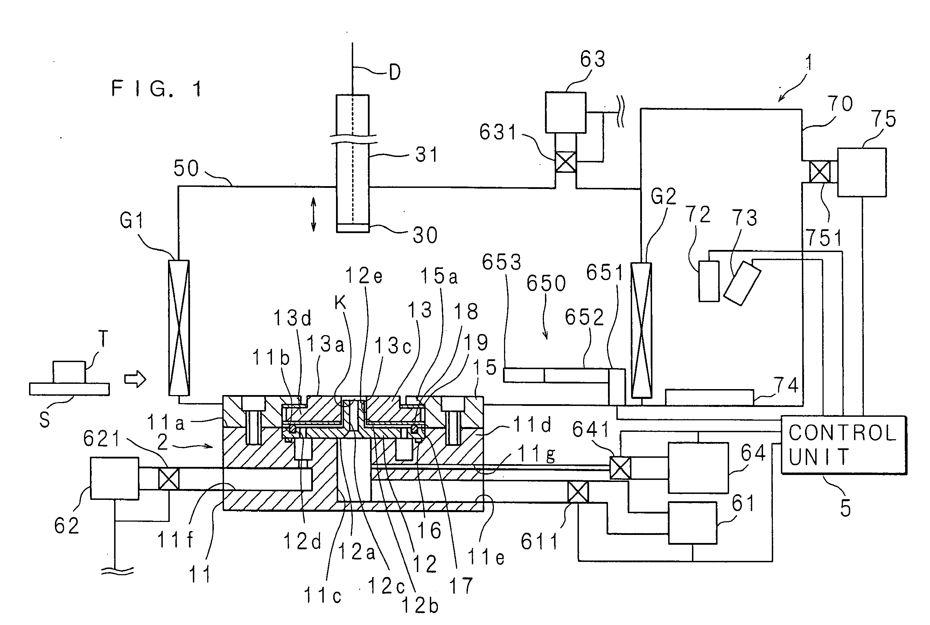

Embodiments are described with reference to the drawings. FIG. 1 is a schematic diagram showing a structure of an electron microscope. The electron microscope 1 includes an observation chamber 70 for observing a specimen S, a specimen-exchange chamber 50, a glow-discharge digging unit 2, vacuum gates G1 and G2, a transfer mechanism (transfer means, turn-over means) 650, a first pump 61, a second pump 62, an exchange chamber pump 63, an inside pump 75, and a control unit 5. The electron microscope 1 is for observing the specimen S made of iron, steel, ceramics, or semiconductor in an observation chamber 70. For example, a transmission electron microscope (TEM), a scanning electron microscope (SEM) or a scanning transmission electron microscope (STEM) having features of the TEM and SEM is used as the electron microscope 1. In this embodiment, the scanning electron microscope is used, but the present embodiment is not limited to this example.

The specimen-exchange chamber 50 is provided adjacent to a side surface of the observation chamber 70 through the vacuum gate G2 which maintains a vacuum state in a closed state. The vacuum gate G1 is provided at a position opposed to the vacuum gate G2 of the specimen-exchange chamber 50. The specimen S is transferred from the vacuum gate G1. The glow-discharge digging unit 2 is provided beneath the specimen-exchange chamber 50, and the glow-discharge digging unit 2 digs a surface of the specimen S under control of the control unit 5. Although the glow-discharge digging unit 2 is provided beneath the specimen-exchange chamber 50 in this embodiment, the present embodiment is not limited to this. The glow-discharge digging unit 2 may be provided on or above the specimen-exchange chamber 50 or on a side thereof.

For example, a rotary pump or a turbo molecular pump is used as the first pump 61 and the second pump 62 which are a digging unit exhausting unit (an exhausting unit for a digging unit 2). The first pump 61 and the second pump 62 evacuate the glow-discharge digging unit 2 into vacuum in accordance with instructions of the control unit 5. For example, a turbo molecular pump is used as the exchange chamber pump 63 which is an exchange chamber exhausting unit (an exhausting unit for an specimen-exchange chamber 50), and the exchange chamber pump 63 evacuates the specimen-exchange chamber 50 into vacuum in accordance with instructions of the control unit 5. For example, a turbo molecular pump is used as the inside pump 75, and the inside pump 75 evacuates the observation chamber 70 into vacuum in accordance with instructions of the control unit 5.

The outline of the present embodiment is described below. The control unit 5 opens the vacuum gate G1 in a state where the vacuum gate G2 is closed, and places the specimen S on the glow-discharge digging unit 2 to dig the specimen S. The control unit 5 closes the vacuum gate G1, then operates the first pump 61, the second pump 62, and the exchange chamber pump 63, and evacuates the specimen-exchange chamber 50 and the glow-discharge digging unit 2 having atmospheric pressure until pressures therein become equal to a first pressure such as several hundred Pascal. Thereafter, the control unit 5 digs the specimen S.

After the digging operation is completed, the control unit 5 operates the exchange chamber pump 63, and evacuates the specimen-exchange chamber 50 until the pressure in the specimen-exchange chamber 50 becomes equal to a second pressure of, e.g., several Pascal or less that is lower than the first pressure. The second pressure may be equal to a pressure when observation is carried out in the observation chamber 70. Similarly, the control unit 5 operates the inside pump 75, and evacuates the observation chamber 70 until a pressure therein becomes equal to the second pressure. The control unit 5 opens the vacuum gate G2 in a state where the vacuum gate G1 is closed. The transfer mechanism 650 grasps the specimen S, turns the specimen S upside down, and transfers the specimen S to the observation chamber 70. The control unit 5 closes the vacuum gate G2. Lastly, the control unit 5 observes the digged surface of the specimen S. Details thereof are described below.

The specimen-exchange chamber 50 includes the vacuum gates G1 and G2, the glow-discharge digging unit 2, a holder 31, an oscillator 30, the exchange chamber pump 63, an exchange chamber valve 631, the transfer mechanism 650, the first pump 61, a first valve 611, the second pump 62, a second valve 621, a gas supply unit 64, and a gas valve 641. A holder 31 capable of extending and contracting in the vertical direction penetrates a substantially central portion of an upper surface of the specimen-exchange chamber 50. The holder 31 abuts the specimen S against the glow-discharge digging unit 2 through the oscillator 30 and a specimen stage T. The holder 31 extends and contracts under control of the control unit 5.

The specimen stage T made of a conductive metal such as aluminum is applied onto a back side of an observation surface of the specimen S by means of a carbon tape or the like. A user places the specimen S on a substantially central portion of an electrode 12 of the glow-discharge digging unit 2 such that the specimen stage T is oriented upward, i.e., the observation surface is oriented downward. The oscillator 30 is mounted on a tip end of the holder 31, and the oscillator 30 supplies, via the specimen stage T, a voltage supplied to the specimen S and the electrode 12 through a power supply line D. The exchange chamber pump 63 is provided on an upper surface of the specimen-exchange chamber 50.

When air in the specimen-exchange chamber 50 is exhausted, the exchange chamber pump 63 having the exchange chamber valve 631 opens the exchange chamber valve 631, and supplies and exhausts air until a pressure in the specimen-exchange chamber 50 becomes equal to a value which is predetermined by a pressure sensor (not shown) in the specimen-exchange chamber 50. In the present embodiment, an example in which the exchange chamber pump 63 is provided on an upper surface of the specimen-exchange chamber 50 for the sake of convenience of the paper space, but the embodiment is not limited to this embodiment. When the glow-discharge digging unit 2 is provided beneath the specimen-exchange chamber 50, it is preferred that the exchange chamber pump 63 is also provided near the glow-discharge digging unit 2 located at a low position. There is a concern that an article to be processed scatters in the specimen-exchange chamber 50 by sputtering carried out by the glow-discharge digging unit 2. However, by placing the exchange chamber pump 63 at the low position like the glow-discharge digging unit 2 located at the low position, it is possible to suck the article to be processed effectively without scattering the article which receives influence of gravity.

Next, details of the glow-discharge digging unit 2 are described. A portion of the glow-discharge digging unit 2 projects from a bottom surface of the specimen-exchange chamber 50. A short cylindrical lamp body 11, the electrode 12, a ceramics member 13, and a pressure block 15 are combined with each other to constitute the glow-discharge digging unit 2. A depression 11b is formed in a central portion of an end surface 11a of the lamp body 11. A pressure block 15 is combined with the end surface 11a. The electrode 12 is provided in the depression 11b. A center hole 11c is formed in a center portion of the depression 11b. A plurality of suction holes 11e and 11f for evacuation are formed in the lamp body 11 so as to extend from a peripheral wall 11d toward a center of the lamp body 11. One of the suction holes (11e) is in communication with the center hole 11c, and the other suction hole (11f) is in communication with the depression 11b. A gas supply hole 11g is formed in the lamp body 11 such that the gas supply hole 11g is in communication with the center hole 11c. The gas supply hole 11g extends from the peripheral wall 11d toward the center of the lamp body 11. Inert gas such as argon gas or neon gas is supplied through the gas supply hole 11g. A supply operation of argon gas is described below.

The electrode 12 contained in the depression 11b of the lamp body 11 has such a shape that a cylindrical portion (end) 12b of the electrode 12 projects from a center of a disk portion 12a thereof. A through hole 12c penetrating from inside of the cylindrical portion 12b through the disk portion 12a is formed in the electrode 12. A hole 12d is formed also in the disk portion 12a. If the electrode 12 is mounted on the depression 11b of the lamp body 11, the electrode 12 is at the grounding potential through the lamp body 11. In order to maintain the hermeticity of the center hole 11c of the lamp body 11 and the through hole 12c of the electrode 12 in a state where the electrode 12 is contained, a first O-ring 16 is mounted between the lamp body 11 and the electrode 12.

The ceramics member 13 is disposed so as to cover the electrode 12. The ceramics member 13 is a thick disk-like member. The ceramics member 13 includes a projecting flange 13d covering the disk portion 12a of the electrode 12. An insertion hole 13c through which the cylindrical portion 12b of the electrode 12 is inserted is formed in a center portion of the ceramics member 13. The ceramics member 13 is disposed so as to be opposed to the disk portion 12a of the electrode 12 through a heat-resistant first insulator 17. In a state where the ceramics member 13 is disposed, a predetermined gap is formed between the insertion hole 13c of the ceramics member 13 and the cylindrical portion 12b of the electrode 12, and a tip end 12e of the cylindrical portion 12b does not project from an end surface 13a of the ceramics member 13. A second O-ring 18 is mounted between the first insulator 17 and the disk portion 12a of the electrode 12 to maintain the hermeticity.

The pressure block 15 is an annular member for fixing the electrode 12 and the ceramics member 13 to the lamp body 11. The pressure block 15 is provided at its inner peripheral edge with a projecting portion 15a, and the projecting portion 15a pushes the flange 13d of the ceramics member 13 toward the lamp body 11. The pressure block 15 itself is mounted on the end surface 11a of the lamp body 11 through a bolt. A heat-resistant second insulator 19 is interposed between the projecting portion 15a of the pressure block 15 and the flange 13d of the ceramics member 13.

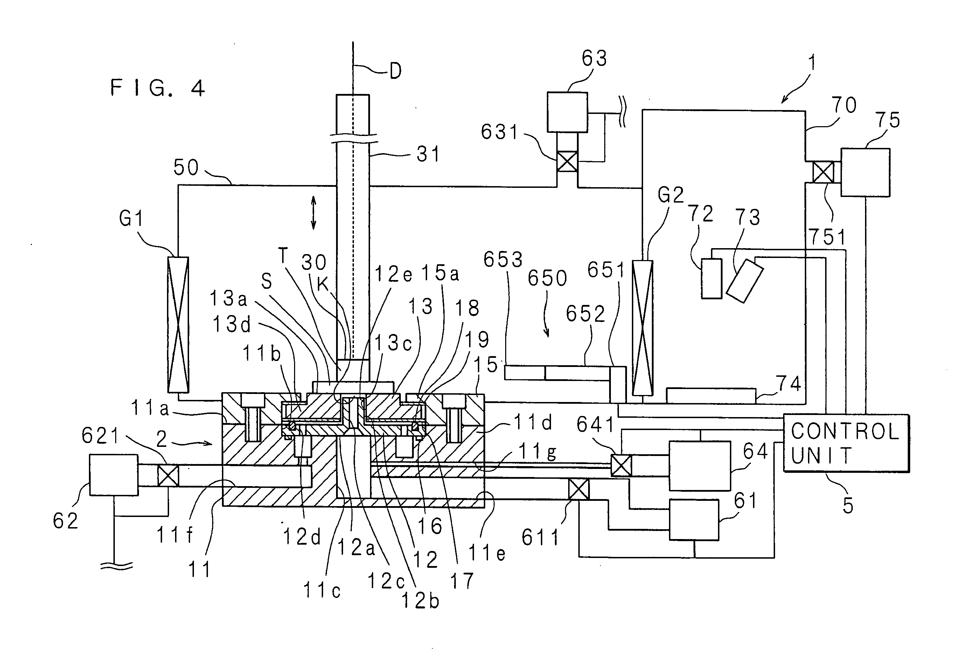

The flat plate-like specimen S which is to be digged and which is mounted on the glow-discharge digging unit 2 is disposed such that a surface of the specimen S abuts against the end surface 13a of the ceramics member 13. Further, a back surface of the specimen S is pushed by the oscillator 30 in this state, and the specimen S is pushed toward the glow-discharge digging unit 2 (see later-described FIG. 4). Because of this, a closed space K is formed at a location where a surface of the specimen S and the tip end 12e of the cylindrical portion 12b of the electrode 12 are opposed to each other. In this manner, the back surface of the specimen S is pushed by the oscillator 30, and a distance between the specimen S and the tip end 12e of the electrode 12, or a volume of the closed space K is defined. Therefore, a to-be-digged surface having high smoothness can be formed at all times.

A suction hole 11e of the lamp body 11 is connected to the first pump 61, and the suction hole 11f is connected the second pump 62. The gas supply hole 11g is connected to the gas supply unit 64. When a suction operation is started by the first pump 61 and the second pump 62 in a state where the specimen S is mounted on the glow-discharge digging unit 2, the suction holes 11e and 11f, the center hole 11c, the through hole 12c of the electrode 12, and the space K are brought into vacuum states. Thereafter, when the control unit 5 operates the gas supply unit 64 to start the supply of argon gas, the gas supply hole 11g, the center hole 11c, the through hole 12c of the electrode 12, and the space K are filled with argon gas. Although the gas supply unit 64 supplies argon gas into the glow-discharge digging unit 2 in this embodiment, the argon gas may also be supplied to the specimen-exchange chamber 50 separately.

The transfer mechanism 650 includes a support shaft 651, an arm 652, and a grasping unit 653. The grasping unit 653 grasps the specimen stage T and places the specimen S on the glow-discharge digging unit 2. After the digging operation, the grasping unit 653 turns the specimen S over. The support shaft 651 and the arm 652 are operated, thereby placing the specimen S on an observation stage 74 in the observation chamber 70 in a state where a to-be-digged surface of the specimen S is oriented upward.
The transfer mechanism 650 is described in detail later. The observation chamber 70 includes an electron beam irradiation unit 72, an electron detector 73, an observation stage 74, and an inside pump 75 having an inside valve 751. Details in the observation chamber 70 are also described later.

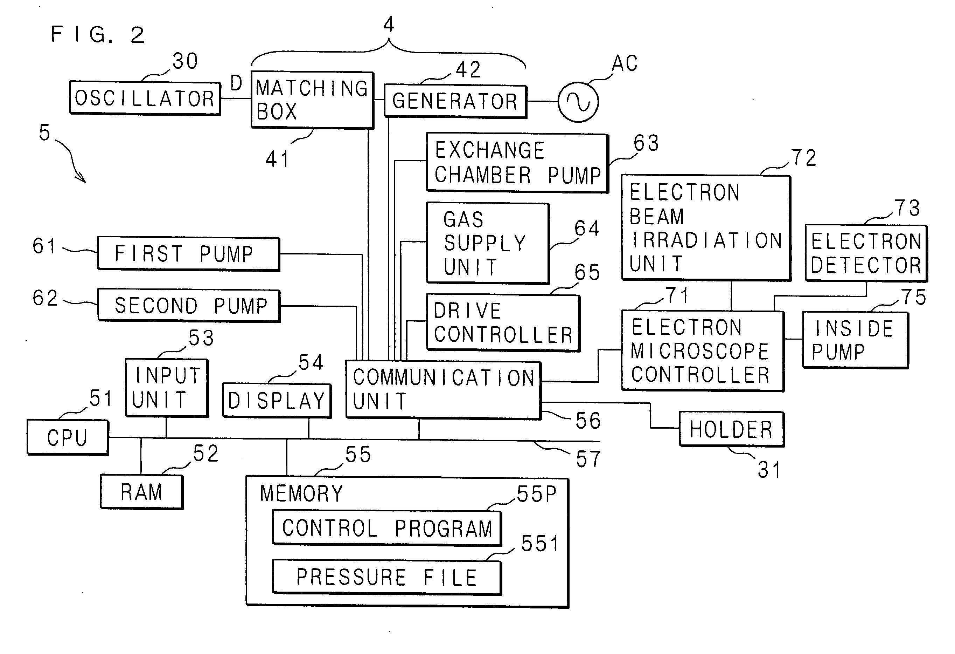

FIG. 2 is a block diagram showing a structure of each piece of hardware including the control unit 5. The control unit 5 is constituted by, for example, a personal computer. The control unit 5 includes a CPU (Central Processing Unit) 51 as a control unit, a RAM (Random Access Memory) 52, an input unit 53, a display 54, a memory 55, and a communication unit 56. The CPU 51 is connected to various hardware units of the control unit 5 through a bus 57 and controls them. The CPU 51 executes various software functions in accordance with a control program 55P stored in the memory 55.

The RAM 52 is a semiconductor device or the like, and writes and reads necessary information in accordance with instructions of the CPU 51. The display 54 is, for example, a liquid crystal display or an organic EL display. The input unit 53 includes a keyboard and a mouse. The input unit 53 may be a touch pad laminated on the display 54. The memory 55 is a hard disk or a large-capacity memory, and a pressure file 551 is stored in the memory 55 in addition to the control program 55 P. A first pressure and a second pressure are stored in the pressure file 551. The first pressure and the second pressure are referred to when air is exhausted from the observation chamber 70, the specimen-exchange chamber 50, and the glow-discharge digging unit 2. A user can input values of the first pressure and the second pressure from the input unit 53.

In this case, the CPU 51 receives the inputted first pressure and second pressure, and stores them in the pressure file 551. The first pressure which is low vacuum may be 200 Pa ± 5%, and the second pressure which is higher vacuum than the first pressure may be several Pascal ± 5%, and may be in a predetermined range. In this embodiment, it is not necessary that the first pressure in the specimen-exchange chamber 50 and the first pressure in the glow-discharge digging unit 2 strictly match with each other, and a slight error is tolerated. The above-described numerical pressure values are merely examples, and the present embodiment is not limited to them.

The communication unit 56 is an interface for sending and receiving information between the devices such as the first pump 61. Connected to the communication unit 56 are the first pump 61, the second pump 62, a matching box 41 and a generator 42 which are power supply sets 4 of the glow-discharge digging unit 2, an exchange chamber pump 63, the gas supply unit 64, the holder 31, a drive controller 65, and the like. These devices are operated in accordance with instructions of the CPU 51. The communication unit 56 is also connected to an electron microscope controller 71, and sends and receives necessary information between the communication unit 56 and the electron microscope controller 71.

The electron microscope controller 71 is connected to the electron beam irradiation unit 72, the inside pump 75, and the electron detector 73, and the electron microscope controller 71 controls these devices. In this embodiment, the electron microscope controller 71 controls the devices in the observation chamber 70, but the embodiment is not limited to this. For example, the CPU 51 may control the electron beam irradiation unit 72 and the like instead of the electron microscope controller 71.

The power supply 4 is connected to an AC power supply AC of 220 V. The power supply 4 includes the generator 42 which produces high frequency electric power and the matching box 41. The generator 42 and the matching box 41 are connected to the CPU 51 through the communication unit 56. The generator 42 generates high frequency electric power, and the matching box 41 adjusts the high frequency electric power generated by the generator in accordance with instructions of the CPU 51. The matching box 41 outputs predetermined high frequency electric power to the oscillator 30 connected to the matching box 41 through the power supply line D under control of, e.g., PWM (pulse-width modulation). The matching box 41 applies intermittent high frequency voltage between the specimen stage T, the specimen S, and the electrode 12.

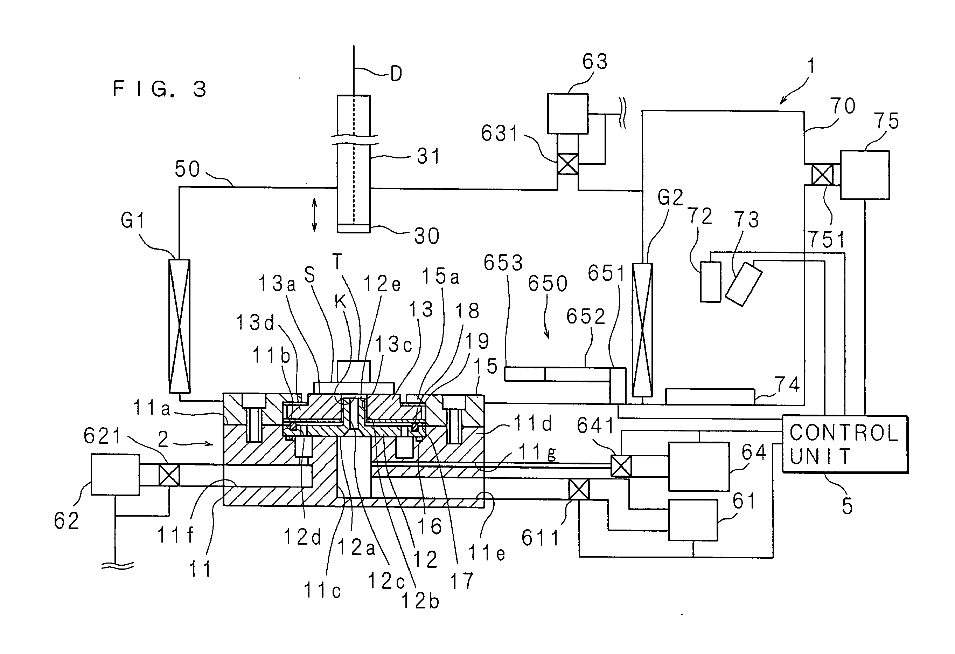

FIGS. 3 to 7 are explanatory diagrams showing a structure and a state transition of the electron microscope. The processing from the carrying-in operation of the specimen S to the observation in the observation chamber 70 is described using FIGS. 1, and 3 to 7. A user applies, on the specimen stage T, a surface of the specimen S that is opposite the to-be-digged surface, and carries the specimen S into the specimen-exchange chamber 50 whose vacuum gate G1 is opened. This carrying-in operation may be carried out manually, by the transfer mechanism 650, or by another carrying-in robot (not shown). At that time, the pressure in the specimen-exchange chamber 50 is equal to the atmospheric pressure. The to-be-digged surface of the specimen S is oriented downward as shown in FIG. 3, and the specimen S is placed such that it is opposed to the through hole 12c which is substantially a central portion of the electrode 12.

When the CPU 51 receives a signal indicative of start of observation from the input unit 53, the CPU 51 activates the control program 55P and carries out the following processing. As shown in FIG. 4, the CPU 51 moves the holder 31 such that the holder 31 is oriented downward until the oscillator 30 comes into contact with the upper surface of the specimen stage T. The CPU 51 closes the vacuum gates G1 and G2, and reduces the pressure in the specimen-exchange chamber 50 and the glow-discharge digging unit 2 from the atmospheric pressure to the first pressure. The CPU 51 opens the exchange chamber valve 631, the first valve 611 and the second valve 621, and closes the gas valve 641. The CPU 51 exhausts air in the specimen-exchange chamber 50 to the outside by the exchange chamber pump 63. The CPU 51 exhausts air in the suction holes 11e and 11f, the center hole 11c, the through hole 12c of the electrode 12, and the space K in the glow-discharge digging unit 2 to the outside by the first pump 61 and the second pump 62.

When pressures which are outputted from sensors in the exchange chamber pump 63, the first pump 61, and the second pump 62 reach the first pressure, the CPU 51 closes the exchange chamber valve 631, the first valve 611, and the second valve 621, and stops the exchange chamber pump 63, the first pump 61, and the second pump 62. In this manner, pressures in the gas supply hole 11g, the center hole 11c, the through hole 12c of the electrode 12, and the space K become equal to the first pressure. Next, the CPU 51 opens the gas valve 641, and starts supplying argon gas. Sensors which detect the pressure may be provided in the specimen-exchange chamber 50, the glow-discharge digging unit 2, and the observation chamber 70, respectively. The first pressure may be set to such a value that argon gas in the glow-discharge digging unit 2 flows to the specimen-exchange chamber 50.

The CPU 51 operates the power supply 4, and the power supply 4 supplies high frequency voltage to the oscillator 30. The high frequency voltage is supplied from the power supply 4 to the oscillator 30 in an argon gas atmosphere. In this manner, a voltage is applied between the electrode 12 and the specimen S, and glow discharge is generated between the electrode 12 and the specimen S. When the glow discharge is generated, sputtering is generated on the surface of the specimen S with argon ions, and the specimen S is digged.

Next, pressures in the specimen-exchange chamber 50 and the glow-discharge digging unit 2 are reduced to the second pressure which is lower than the first pressure. The CPU 51 closes the gas valve 641, and opens the exchange chamber valve 631, the first valve 611, and the second valve 621. The CPU 51 exhausts air in the specimen-exchange chamber 50 to the outside by the exchange chamber pump 63. The CPU 51 exhausts air in the suction holes 11e and 11f, the center hole 11c, the through hole 12c of the electrode 12, and the space K in the glow-discharge digging unit 2 to the outside by the first pump 61 and the second pump 62.

When pressures which are outputted from the sensors of the exchange chamber pump 63, the first pump 61, and the second pump 62 reach the second pressure, the CPU 51 closes the exchange chamber valve 631, the first valve 611, and the second valve 621, and stops the exchange chamber pump 63, the first pump 61, and the second pump 62. In this manner, processed material generated by the digging operation and argon gas can be discharged from the specimen-exchange chamber 50, and it is possible to prevent a foreign substance from flowing into the observation chamber 70. In parallel with this, the CPU 51 outputs, to the electron microscope controller 71, a starting signal indicating that vacuum control is started. The electron microscope controller 71 opens the inside valve 751 provided in the observation chamber 70, operates the inside pump 75, and exhausts air in the observation chamber 70 to the outside. When a sensor (not shown) in the observation chamber 70 determines that the pressure reaches the second pressure, the electron microscope controller 71 outputs, to the CPU 51, a completion signal indicating that the vacuum control is completed.

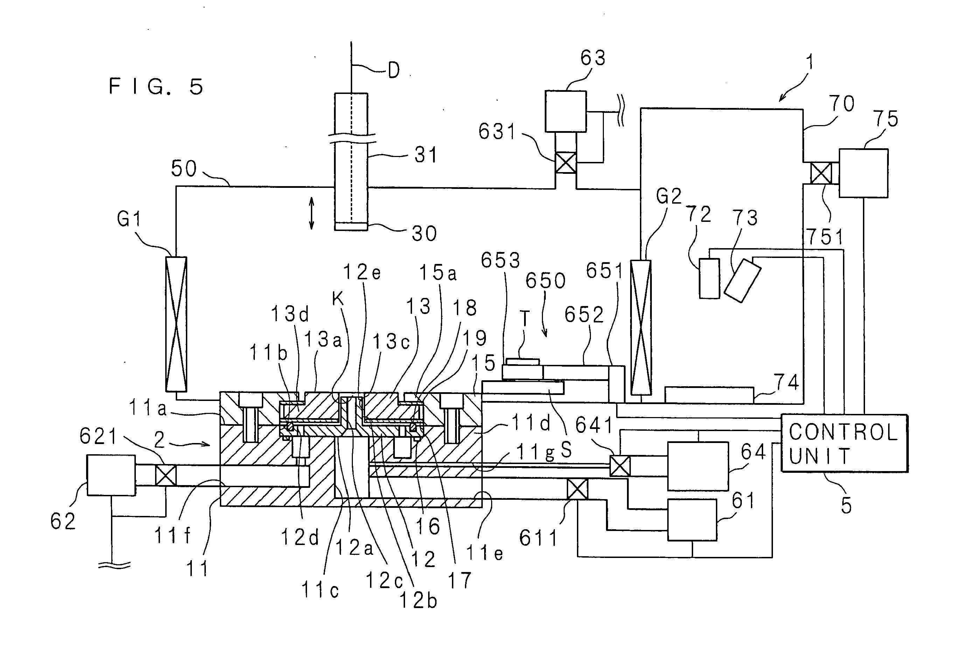

In this manner, the pressures in the observation chamber 70 and the specimen-exchange chamber 50 are reduced to the second pressure which corresponds to a degree of vacuum necessary for both the chambers at the time of observation. Thereafter, the CPU 51 opens the vacuum gate G2, and transfers the specimen S by the transfer mechanism 650 to the observation stage 74 of the observation chamber 70. The operation of the transfer mechanism 650 is described using FIG. 5. The drive controller 65 controls the support shaft 651, the arm 652, and the grasping unit 653. The support shaft 651 disposed on a bottom surface of the specimen-exchange chamber 50 projects toward an upper surface such that the support shaft 651 can extend and contract. The support shaft 651 turns, raises, and lowers the arm 652 which is connected to a top of the support shaft 651. One end of the arm 652 is connected to the top of the support shaft 651, and the other end of the arm 652 is connected to the grasping unit 653. The arm 652 can extend and contract.

The grasping unit 653 grasps a side of the specimen stage T, and turns the specimen stage T upside down in a state where the grasping unit 653 grasps the specimen stage T. After the digging operation of the glow-discharge digging unit 2 is completed, the CPU 51 outputs, to the drive controller 65, a transfer signal indicative of start of the transfer operation of the specimen S from the specimen-exchange chamber 50 to the observation chamber 70. The drive controller 65 raises the holder 31. The drive controller 65 adjusts the height of the support shaft 651 and then, the grasping unit 653 rotates the support shaft 651 to a direction in which the grasping unit 653 is oriented to the specimen stage T. The drive controller 65 extends the arm 652 to a position where the grasping unit 653 can grasp the specimen stage T.

The drive controller 65 grasps a side of the specimen stage T by the grasping unit 653. It is necessary to turn the specimen stage T and the specimen S upside down. This motion may be carried out in any of the specimen-exchange chamber 50 and the observation chamber 70. In this embodiment, this motion is carried out in the observation chamber 70. The drive controller 65 shrinks the arm 652 to an appropriate position. The drive controller 65 outputs, to the CPU 51, a signal indicating that the grasping operation is completed. The CPU 51 receives this signal and opens the vacuum gate G2. The drive controller 65 rotates the support shaft 651 by 180°, and transfers the specimen stage T and the specimen S into the observation chamber 70. After the drive controller 65 raises the support shaft 651, the drive controller 65 vertically rotates the grasping unit 653 by 180°. In this manner, the specimen stage T is oriented downward, the specimen S is oriented upward, and a to-be-digged surface of the specimen S is oriented upward.

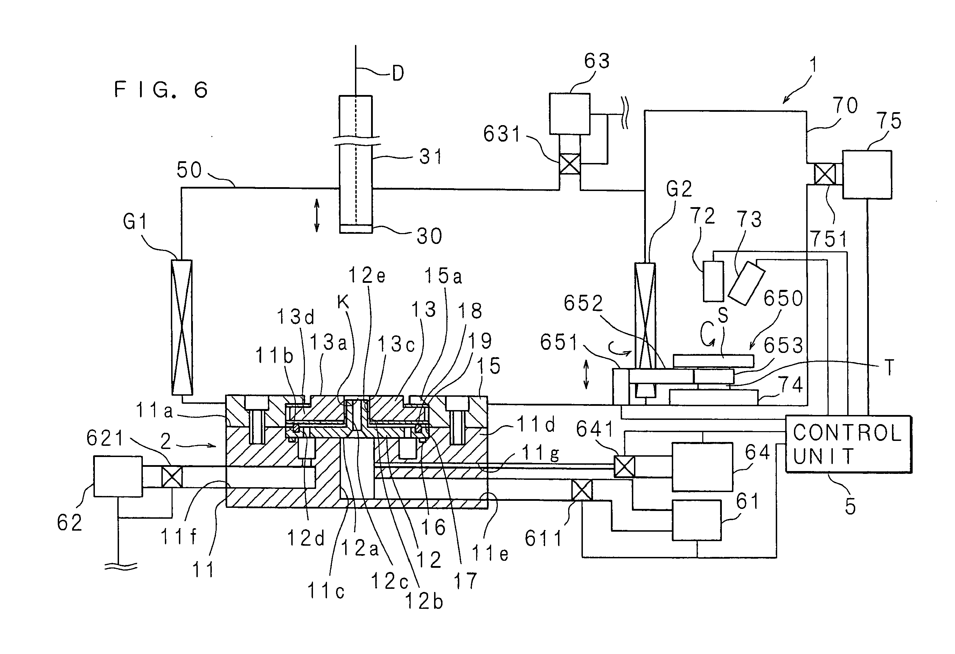

As shown in FIG. 6, the drive controller 65 extends the arm 652 until the grasping unit 653 reaches a substantially central portion of the observation stage 74. The drive controller 65 lowers the support shaft 651 to a predetermined height, and releases the grasped state of the grasping unit 653. In this manner, the specimen S is placed on the observation stage 74 in a state where the to-be-digged surface of the specimen S is oriented upward. The drive controller 65 shrinks the arm 652 and turns the support shaft 651 by 180°. After the moving operation of the arm 652 into the specimen-exchange chamber 50 is completed, the drive controller 65 outputs a signal indicative of completion of transfer to the CPU 51. The transfer mechanism 650 in this embodiment is one example, and other transfer robot may be employed, or the grasping unit 653, the arm 652, and the support shaft 651 may be manually operated from the outside of the specimen-exchange chamber 50. The CPU 51 closes the vacuum gate G2. The CPU 51 outputs an observation-start signal to the electron microscope controller 71.

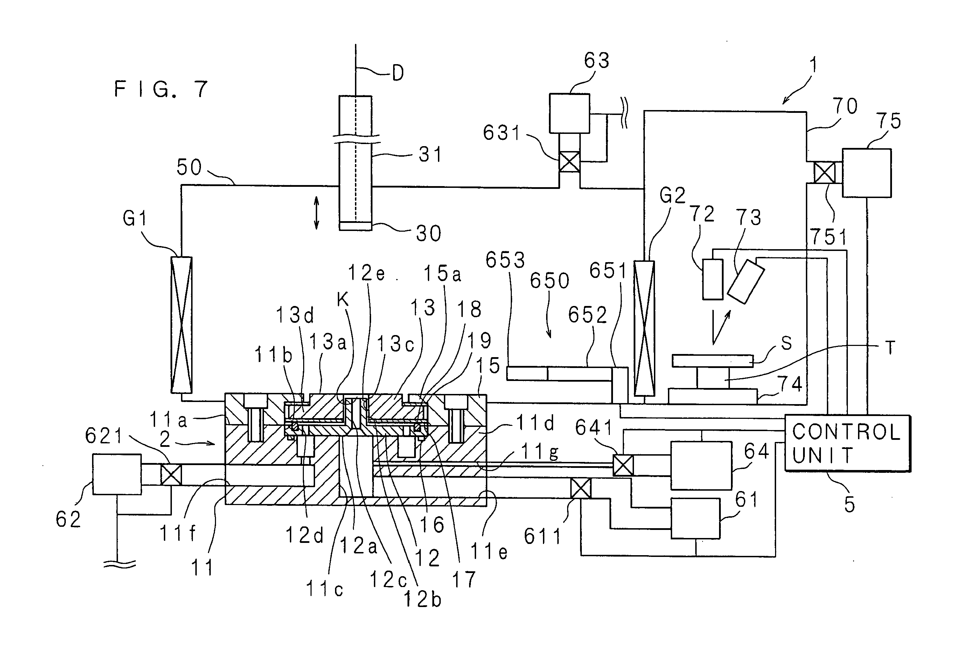

As shown in FIG. 7, the electron microscope controller 71 appropriately moves the observation stage 74, and emits electron beams from the electron beam irradiation unit 72. The to-be-digged surface of the specimen S is irradiated with the electron beams from the electron beam irradiation unit 72, and a reflected electron or secondary electron from the to-be-digged surface is detected by the electron detector 73. Image data indicative of the detection result is outputted to the CPU 51, and the result is indicated on the display 54. The observation stage 74 may be fixed and the electron beam irradiation unit 72 may be scanned.

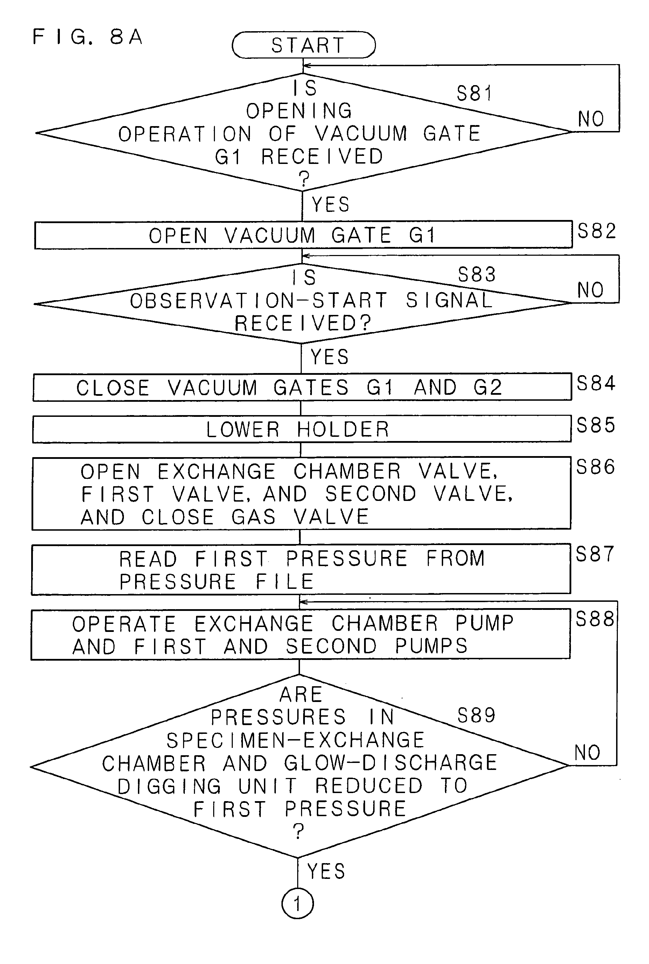

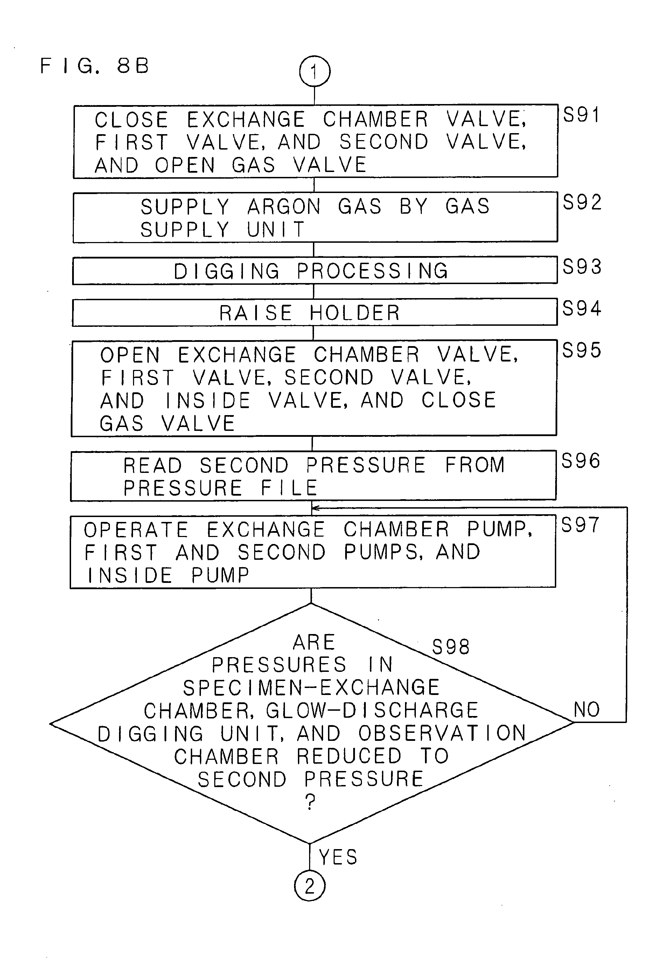

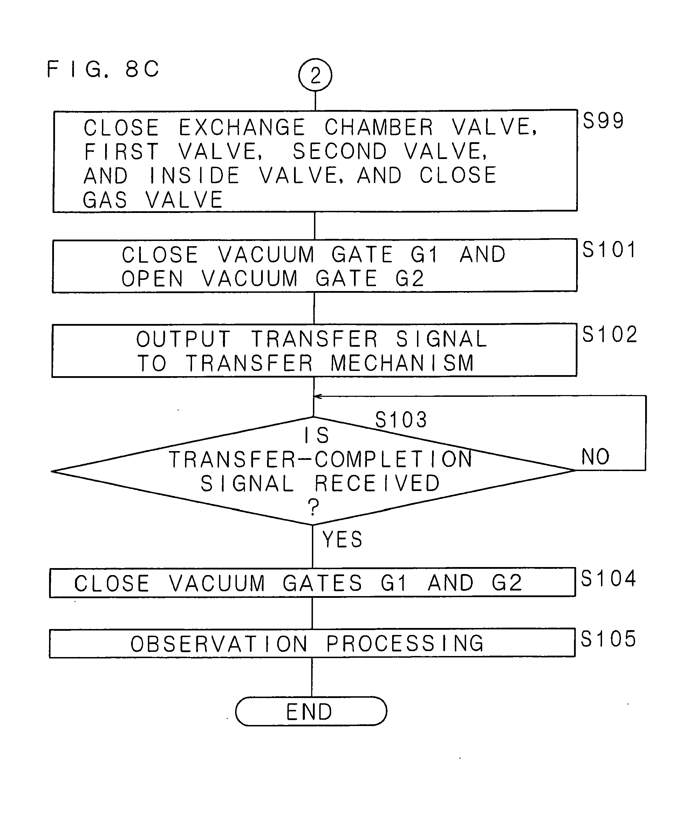

FIGS. 8A to 8C are flowcharts showing a pressure control procedure. The CPU 51 determines whether the CPU 51 receives an opening operation of the vacuum gate G1 from the input unit 53 (step S81). When the CPU 51 does not receive the opening operation of the vacuum gate G1 (NO in step S81), the CPU 51 waits until the opening operation is received. When it is determined that the CPU 51 receives the opening operation of the vacuum gate G1 (YES in step S81), the vacuum gate G1 is opened (step S82). After the specimen S is transferred, the CPU 51 determines whether a signal indicative of start of observation is received from the input unit 53 (step S83). When the CPU 51 does not receive the observation-start signal (NO in step S83), the CPU 51 waits until that signal is received.

When the CPU 51 receives the observation-start signal (YES in step S83), the vacuum gates G1 and G2 are closed (step S84). The CPU 51 lowers the holder 31 (step S85). The CPU 51 opens the exchange chamber valve 631, the first valve 611, and the second valve 621, and closes the gas valve 641 (step S86). The CPU 51 reads the first pressure from the pressure file 551 (step S87). The CPU 51 operates the exchange chamber pump 63, the first pump 61, and the second pump 62 (step S88). The CPU 51 refers to output from the sensor which detects a pressure, and determines whether pressures in the specimen-exchange chamber 50 and the glow-discharge digging unit 2 become equal to the first pressure (step S89).

When the CPU 51 determines that the pressures are not reduced to the first pressure (NO in step S89), the procedure is shifted to step S88, and exhausting processing is continuously carried out. When the CPU 51 determines that the pressures are reduced to the first pressure (YES in step S89), the CPU 51 closes the exchange chamber valve 631, the first valve 611, and the second valve 621, and opens the gas valve 641 (step S91). The CPU 51 outputs, to the gas supply unit 64, a signal indicating argon gas should be supplied (step S92). The CPU 51 outputs, to the power supply 4, a signal indicating that the digging operation should be started. In this manner, the digging operation is started (step S93). Digging conditions such as frequency of applied voltage, digging time, and digging amount are previously inputted from the input unit 53, and the digging conditions are stored in the memory 55.

The CPU 51 upwardly moves the holder 31 (step S94). The CPU 51 opens the exchange chamber valve 631, the first valve 611, the second valve 621, and the inside valve 751, and closes the gas valve 641 (step S95). The CPU 51 reads the second pressure from the pressure file 551 (step S96).
The CPU 51 operates the exchange chamber pump 63, the first pump 61, the second pump 62, and the inside pump 75 (step S97). The CPU 51 refers to the output from the sensor which detects a pressure, and determines whether pressures in the specimen-exchange chamber 50, the glow-discharge digging unit 2, and the observation chamber 70 are reduced to the second pressure (step S98).

When the CPU 51 determines that the pressures are not reduced to the second pressure (NO in step S98), the procedure is shifted to step S97 where the exhausting operation is continuously carried out. When the CPU 51 determines that the pressures are reduced to the second pressure (YES in step S98), the exchange chamber valve 631, the first valve 611, the second valve 621, and the inside valve 751 are closed, and the gas valve 641 is closed (step S99). The CPU 51 closes the vacuum gate G1 and opens the vacuum gate G2 (step S101).

The CPU 51 outputs, to the drive controller 65, a transfer signal (transfer instructions) indicating that the transfer of the specimen stage T and the specimen S should be started (step S102). The drive controller 65 transfers and turns over the specimen stage T and the specimen S, and places the specimen S on the observation stage 74. After the drive controller 65 returns the arm 652 and the grasping unit 653 into the specimen-exchange chamber 50, the drive controller 65 outputs, to the CPU 51, a signal indicating that the transfer operation is completed (step S102). The CPU 51 determines whether the transfer completion signal is received from the drive controller 65 (step S103). If the CPU 51 does not receive the transfer completion signal (NO in step S103), the CPU 51 waits until the transfer completion signal is received.

When the CPU 51 receives the transfer completion signal (YES in step S103), the vacuum gates G1 and G2 are closed (step S104). The CPU 51 outputs a signal indicative of start of observation to the electron microscope controller 71. The electron microscope controller 71 drives the electron beam irradiation unit 72 and carries out observation processing of the specimen S whose digged surface is oriented upward (step S105). In this manner, the digged surface of the specimen S can swiftly be observed without bringing the digged surface into contact with the atmosphere. With the two stage control of the first pressure and the second pressure, processed material and argon gas generated when digging operation is carried out in the specimen-exchange chamber 50 can be discharged, and the inside of the observation chamber 70 can be kept clean. A pressure in the specimen-exchange chamber 50 is adjusted to the first pressure that is low vacuum before reaching super-high vacuum which is required for observation using the electron microscope, and the digging operation is carried out in this state. Therefore, the glow discharge can be stabilized, and the holder 31 which holds the specimen S and the specimen stage T can be stabilized.

### Second Embodiment

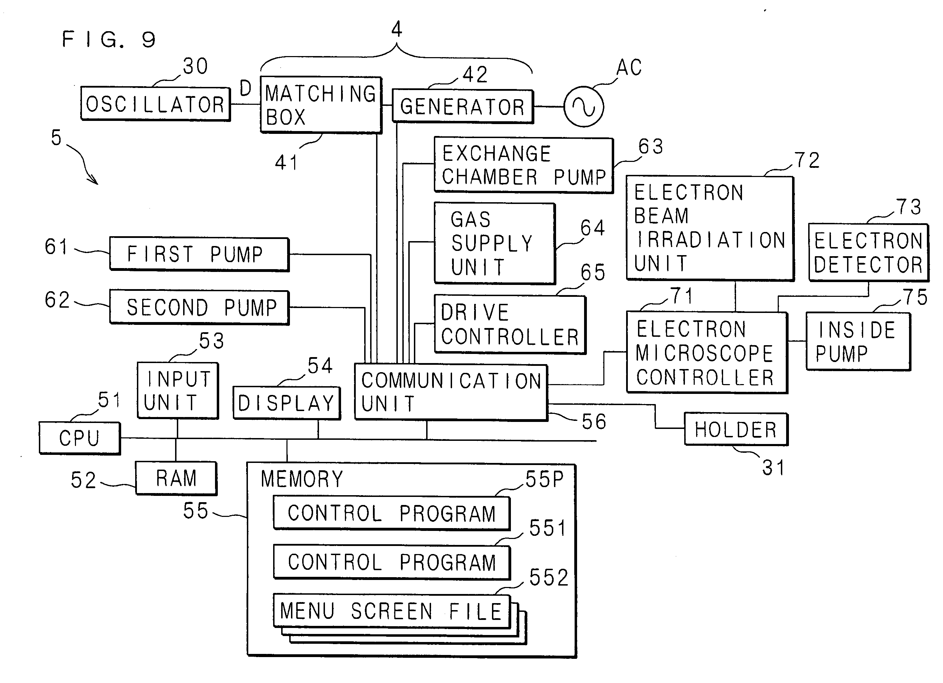

A second embodiment relates to a re-digging operation which is again carried out by the glow-discharge digging unit 2. FIG. 9 is a block diagram showing a structure of each piece of hardware including a control unit 5 according to the second embodiment. A menu screen file 552 is newly prepared for the memory 55 in addition to the structure of the first embodiment. After the observation carried out by the electron microscope controller 71 is completed, the CPU 51 outputs, to the display 54, a selection screen for selecting whether the digging operation should be carried out by the glow-discharge digging unit 2 in the specimen-exchange chamber 50 again, from the menu screen file 552.

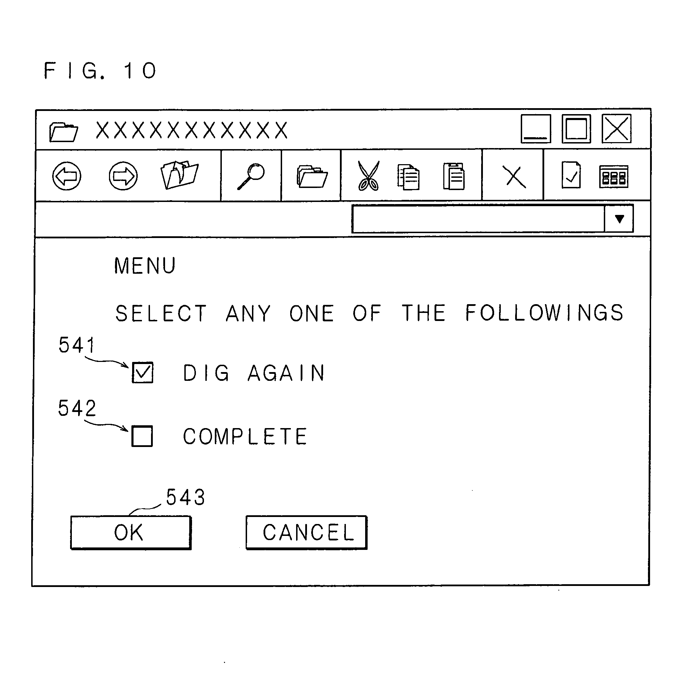

FIG. 10 is an explanatory diagram showing an image of the selection screen. The selection screen is indicated on the display 54 in a pop up manner, and information for selecting one of "digging operation should be carried out again" and "should be completed", and check boxes 541 and 542 corresponding thereto, an OK button 543, and the like are displayed. A user who again desires the digging operation clicks the check box 541 from the input unit 53, and clicks the OK button 543. If the user clicks the check box 541 and the OK button 543, the CPU 51 receives the re-digging information indicating that the digging operation is again carried out by the glow-discharge digging unit 2.

In this case, the specimen S is again digged by the glow-discharge digging unit 2 in the specimen-exchange chamber 50. When the specimen S is to be discharged without carrying out the digging operation, the user clicks the check box 542 indicating completion from the input unit 53 and clicks the OK button 543. In this case, the specimen S is discharged outside. If the CPU 51 receives the re-digging information and while pressures in the specimen-exchange chamber 50 and the glow-discharge digging unit 2 are being adjusted to the second pressure or first pressure, the CPU 51 reads the condition entry screen from the menu screen file 552 for inputting a condition which is necessary for the re-digging operation, and indicates the condition entry screen on the display 54.

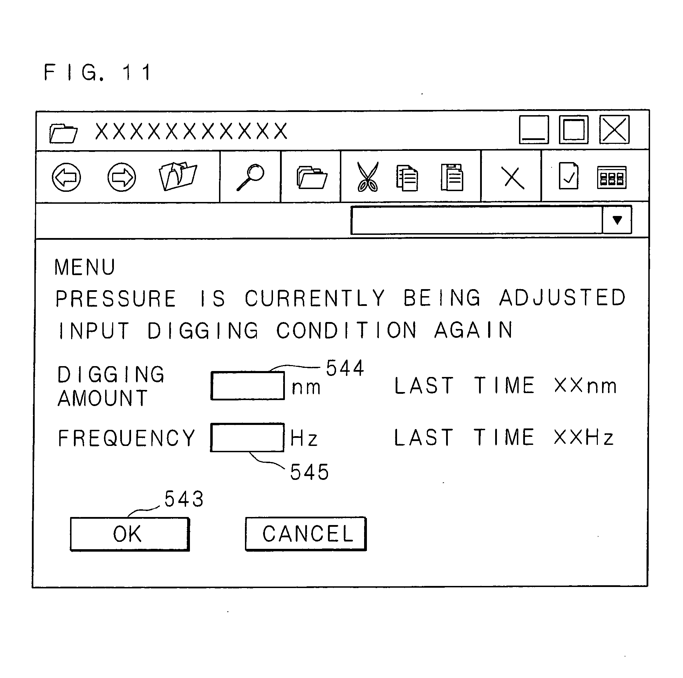

FIG. 11 is an explanatory diagram showing an image of the condition entry screen. The CPU 51 receives inputs of, e.g., a digging amount indicating a re-digging amount and a frequency as the re-digging conditions. This digging condition is one example and the present embodiment is not limited to this. The user inputs the digging amount into the digging amount box 544 through the input unit 53, and inputs frequency of applied voltage into the frequency box 545. The user inputs the OK button 543. The CPU 51 may read and display a digging condition of the last digging operation, i.e., a digging condition in step S93 from the memory 55, and display the digging condition for the convenience of the user. In the example shown in FIG. 11, the last time digging amount and frequency are displayed.

When the OK button 543 is inputted through the input unit 53, the CPU 51 receives the inputted digging amount or frequency, and outputs the received re-digging condition to the power supply 4. The power supply 4 of the glow-discharge digging unit 2 applies voltage and carries out the digging operation in accordance with the re-digging condition. The CPU 51 stores the re-digging condition in the memory 55 like the last time digging condition. When the re-digging operation is thus carried out, since it takes time to adjust a pressure to the second pressure or the first pressure and to introduce the argon gas, the re-digging condition is previously inputted. In this manner, when the re-digging operation is carried out, it is possible to proceed with the procedure swiftly. The last time digging condition stored in the memory 55 is indicated on the display 54 for reference. In this manner, a user can easily determine the re-digging condition. In this embodiment, an example is described in which the re-digging information is received, and when a pressure in the specimen-exchange chamber 50 is reduced to the second pressure, the condition entry screen is indicated, and the input of the re-digging condition is received, but the present embodiment is not limited to this. For example, the re-digging information is received, and when the pressure in the specimen-exchange chamber 50 is reduced to the first pressure, the condition entry screen may be indicated and the input of the re-digging condition may be received.

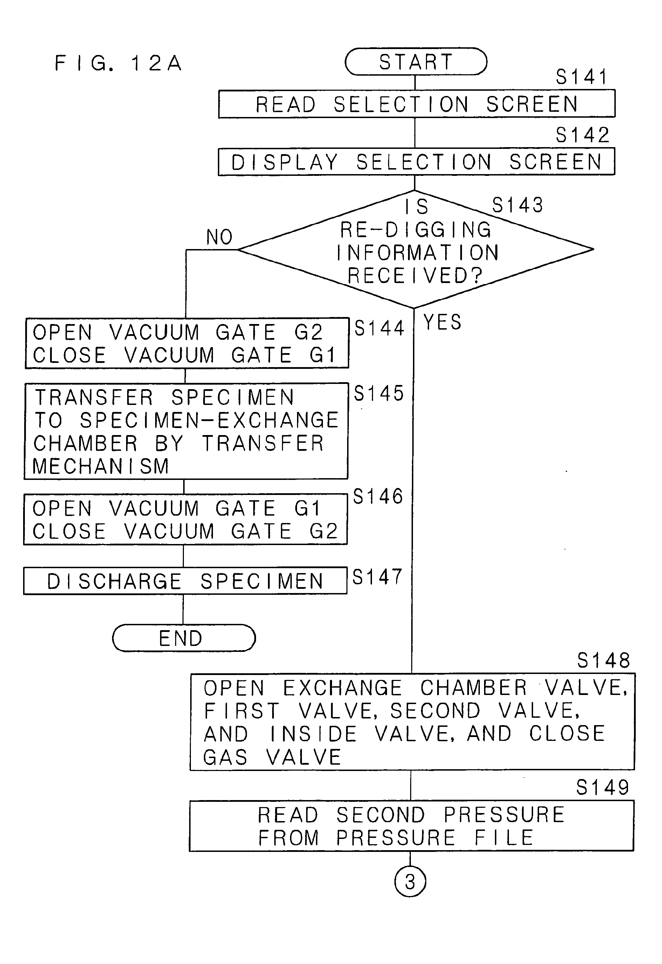

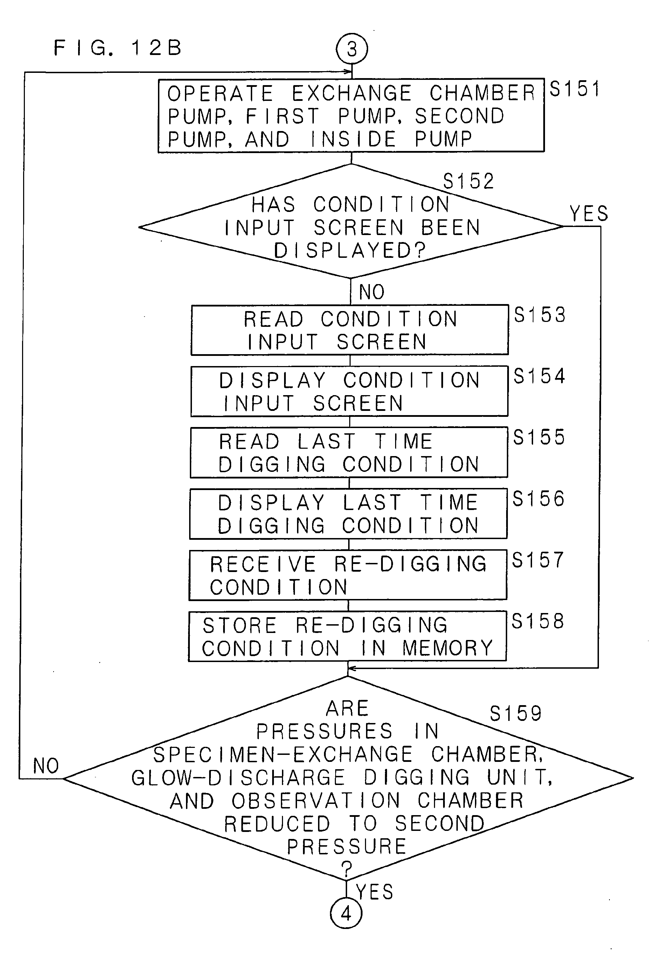

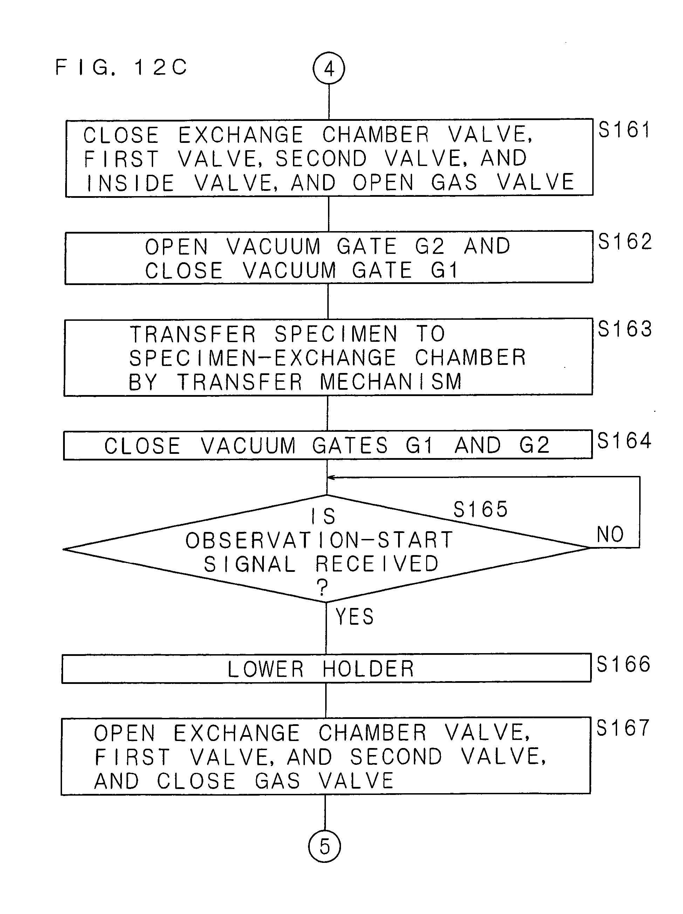

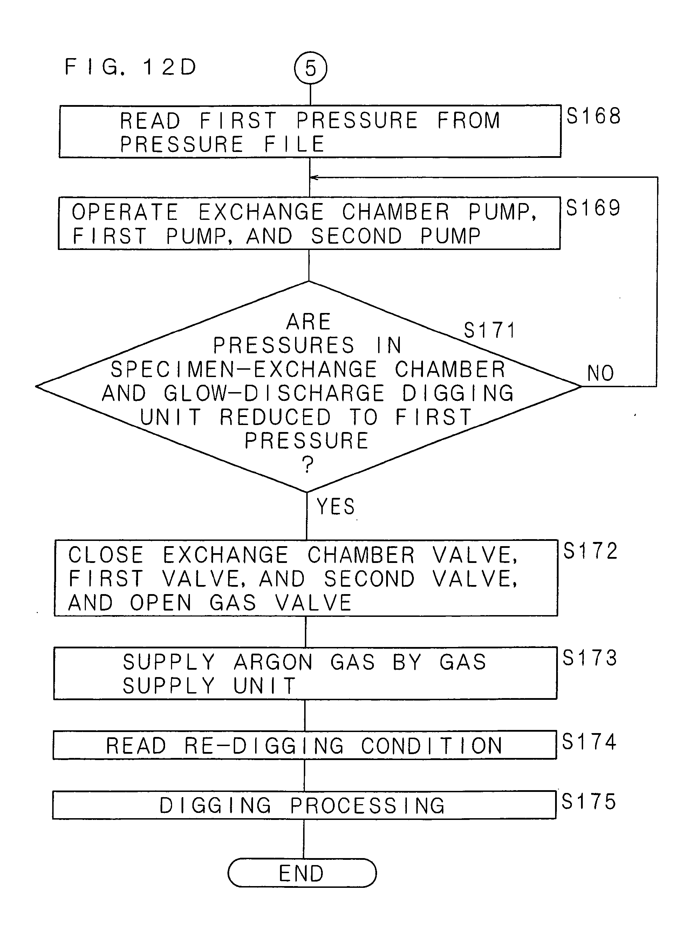

In the above-described hardware structure, a procedure of the re-digging process is described using flowcharts. FIGS. 12A to 12D are flowcharts showing a procedure of the re-digging process. After the process in step S105, the CPU 51 reads a selection screen from the menu screen file 552 (step S141). The CPU 51 indicates the selection screen on the display 54 as shown in FIG. 10 (step S 142). The CPU 51 determines whether the re-digging information is received from the input unit 53 (step S143). More specifically, it is determined whether the check box 541 indicating the re-digging and the OK button 543 are inputted under AND-condition.

When the CPU 51 determines that the re-digging condition is not received (NO in step S143), the vacuum gate G2 is opened and the vacuum gate G1 is closed to discharge the specimen stage T and the specimen S (step S144). The CPU 51 moves the specimen S and the specimen stage T to the specimen-exchange chamber 50 by the transfer mechanism 650 (step S145). Since the detailed action of the transfer mechanism 650 is opposite the action described in the first embodiment, detailed description thereof is not given. The CPU 51 opens the vacuum gate G1 and closes the vacuum gate G2 (step S146). In this manner, the specimen S is discharged (step S147).

When the CPU 51 determines that the re-digging information is received (YES in step S143), the CPU 51 opens the exchange chamber valve 631, the first valve 611, the second valve 621, and the inside valve 751, and closes the gas valve 641 (step S148). The CPU 51 reads the second pressure from the pressure file 551 (step S149). As third control, the CPU 51 operates the exchange chamber pump 63, the first pump 61, the second pump 62, and the inside pump 75 (step S151).

The CPU 51 determines whether the condition entry screen shown in FIG. 11 has already been indicated on the display 54 (step S152). When the CPU 51 determines that the condition entry screen has not yet been indicated (NO in step S 152), the CPU 51 reads the condition entry screen from the menu screen file 552 (step S153) and indicates the condition entry screen on the display 54 (step S 154). The CPU 51 also reads the last time digging condition from the memory 55 (step S155). The CPU 51 indicates the read digging condition on the display 54 (step S156).

The CPU 51 receives the input of the re-digging condition from the input unit 53 (step S157). The CPU 51 stores the received re-digging condition in the memory 55 (step 5158). As the re-digging condition, date from a clock (not shown) may be referred to, and this may be stored in the memory 55 as history information. The CPU 51 refers to the output from the sensor which detects a pressure, and determines whether pressures in the specimen-exchange chamber 50, the glow-discharge digging unit 2, and the observation chamber 70 are reduced to the second pressure (step S159).

When the CPU 51 determines that the pressures are not reduced to the second pressure (NO in step S 159), the procedure is shifted to step S151, and the exhausting processing is continuingly carried out. When the CPU 51 determines in step S152 that the condition entry screen has already been indicated (YES in step S152), and steps S153 to S158 are skipped. When the CPU 51 determines that that the pressures are reduced to the second pressure (YES in step S159), the exchange chamber valve 631, the first valve 611, the second valve 621, and the inside valve 751 are closed, and the gas valve 641 is closed (step S161). The CPU 51 closes the vacuum gate G1 and opens the vacuum gate G2 (step S162).

The CPU 51 moves the specimen S and the specimen stage T to the specimen-exchange chamber 50 by the transfer mechanism 650 (step S163). In this case, as described above, the grasping unit 653 grasps the specimen stage T in the specimen-exchange chamber 50 or in the observation chamber 70, and turns the specimen stage T upside down such that the digged surface of the specimen S is oriented downward. The CPU 51 closes the vacuum gates G1 and G2 (step S164). The CPU 51 determines whether a signal indicating that observation should be started is received from the input unit 53 (step S165). When the CPU 51 does not receive the signal indicating that observation should be started (NO in step S165), the CPU 51 waits until the signal is received.

When the CPU 51 receives the observation-start signal (YES in step S165), the CPU 51 lowers the holder 31 (step S166). The CPU 51 opens the exchange chamber valve 631, the first valve 611, and the second valve 621, and closes the gas valve 641 (step S167). The CPU 51 reads the first pressure from the pressure file 551 (step S168). As fourth control, the CPU 51 operates the exchange chamber pump 63, the first pump 61, and the second pump 62 (step S169). The CPU 51 refers to the output of the sensor which detects a pressure, and determines whether the pressures in the specimen-exchange chamber 50 and the glow-discharge digging unit 2 are reduced to the first pressure (step S171). The processing of steps S 152 to S 158 may be executed between steps S169 and S171.

When the CPU 51 determines that the pressures are not reduced to the first pressure (NO in step S171), the procedure is shifted to step S169, and the exhausting processing is carried out continuously. When the CPU 51 determines that the pressures are reduced to the first pressure (YES in step S171), the exchange chamber valve 631, the first valve 611, and the second valve 621 are closed, and the gas valve 641 is opened (step S172).
The CPU 51 outputs, to the gas supply unit 64, a signal indicating that argon gas should be supplied (step S173). The CPU 51 reads the re-digging condition stored in the memory 55 (step S174). The CPU 51 outputs, to the power supply 4, a signal indicating that the re-digging condition and the digging operation should be started. Thereafter, the power supply 4 of the glow-discharge digging unit 2 carries out the digging operation of the specimen S in accordance with the re-digging condition (step S175). In this manner, even when it is necessary that the specimen S is digged again, a series of processing of the digging operation and observation of the digged surface can be carried out swiftly without bringing the specimen S into contact with the atmosphere.

The second embodiment has the above-described structure, and other structure and effect are the same as those of the first embodiment and thus, the corresponding portions are designated with the same reference numerals, and detailed description thereof is not given.

### Third Embodiment

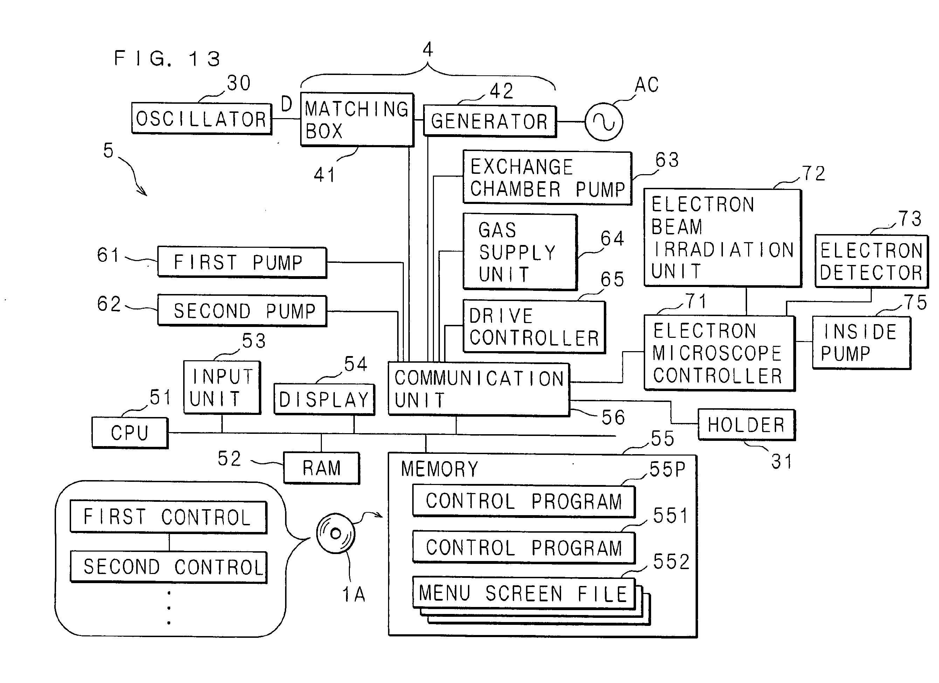

FIG. 13 is a block diagram showing a structure of each piece of hardware including a control unit 5 according to a third embodiment. A computer program for operating the control unit 5 according to the third embodiment can also be provided in the form of a portable recording medium 1A such as a CD-ROM and a memory card like the third embodiment.
Further, the computer program is also downloadable from a server computer (not shown) through a communication network such as a LAN or the Internet. Contents thereof are described below.

The portable recording medium 1A in which a computer program for executing the above-described processing is stored is inserted into a recording medium reader (not shown) of the control unit 5 shown in FIG. 13, and this program is installed in a program in the memory 55. Alternatively, this program may be downloaded from an external server computer (not shown) through a communication unit (not shown) and may be installed in the memory 55. This program is loaded into the RAM 52 and executed. In this manner, the control unit 5 functions as described above.

The third embodiment has the above-described structure, and other structure and effect are the same as those of the first and second embodiments and thus, the corresponding portions are designated with the same reference numerals, and detailed description thereof is not given.
All examples and conditional language recited herein are intended for pedagogical purposes to aid the reader in understanding the principles of the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. An electron microscope (1) for observing a specimen (S) in an observation chamber (70) **characterized by** comprising:
a specimen-exchange chamber (50) which is provided adjacent to the observation chamber (70) and which is provided therein with a glow-discharge digging unit (2);
an exchange chamber exhausting unit (63) for exhausting air in the specimen-exchange chamber (50);
a digging unit exhausting unit (61,62) for exhausting air in the glow-discharge digging unit (2);
first control means for controlling pressures in the specimen-exchange chamber (50) and the glow-discharge digging unit (2) to a first pressure when the specimen (S) is transferred into the specimen-exchange chamber (50) by the exchange chamber exhausting unit (63)and the digging unit exhausting unit (61,62);
second control means for controlling a pressure in the specimen-exchange chamber (50) to a second pressure which is lower than the first pressure by the exchange chamber exhausting unit (63) after the pressures are controlled to the first pressure by the first control means and the specimen (S) is digged by the glow-discharge digging unit (2); and
transfer means (650) for transferring the specimen (S) to the observation chamber (70) after the pressure is controlled to the second pressure by the second control means.

2. The electron microscope (1) according to claim 1, wherein
the glow-discharge digging unit (2) is provided at a lower portion in the specimen-exchange chamber (50), and
the electron microscope (1) further comprises turn-over means (650) for turning over the specimen when the specimen (S) is transferred by the transfer means (650).

3. The electron microscope (1) according to claim 1 or 2 further comprising:
receiving means for receiving re-digging information indicating that a digging operation is again carried out by the glow-discharge digging unit (2) after the specimen (S) is observed in the observation chamber (70);
third control means for controlling a pressure in the specimen-exchange chamber to the second pressure by the exchange chamber exhausting unit (63) when the re-digging information is received by the receiving means; and
fourth control means for controlling the pressures in the specimen-exchange chamber (50) and the glow-discharge digging unit (2) to the first pressure by the exchange chamber exhausting unit (63) and the digging unit exhausting unit (61,62) after the third control means controls the pressure to the second pressure and the transfer means (650) transfers the specimen (S) from the observation chamber (70) to the specimen-exchange chamber (50).

4. The electron microscope (1) according to claim 3 further comprising:
means for displaying a screen which receives input of a condition necessary for a re-digging operation by the glow-discharge digging unit (2) when the receiving means receives re-digging information and control is started by the third control means.

5. The electron microscope (1) according to claim 3 further comprising:
means for displaying a screen which receives input of a condition necessary for a re-digging operation by the glow-discharge digging unit (2) when the receiving means receives re-digging information and control is started by the fourth control means.

6. A pressure control method of an electron microscope (1) through which a specimen (S) in an observation chamber (70) is observed **characterized by** comprising:
a step of transferring the specimen (S) into a specimen-exchange chamber (50) which is provided adjacent to the observation chamber (70) and which is provided therein with a glow-discharge digging unit (2);
a first control step of controlling pressures in the specimen-exchange chamber (50) and the glow-discharge digging unit (2) to a first pressure by an exchange chamber exhausting unit (631) which exhausts air in the specimen-exchange chamber (50) and by a digging unit exhausting unit (61,62) which exhausts air in the glow-discharge digging unit (2) when the specimen is transferred into the specimen-exchange chamber (50);
a second control step of controlling a pressure in the specimen-exchange chamber (50) to a second pressure which is lower than the first pressure by the exchange chamber exhausting unit (63) after the pressures are controlled to the first pressure in the first control step and the specimen (S) is digged by the glow-discharge digging unit (2); and
a transfer step of transferring the specimen (S) into the observation chamber (70) by the transfer means (650) after the pressure is controlled to the second pressure in the second control step.

7. A recording medium (1A) storing therein a program used for a computer connected to an electron microscope (1) for observing a specimen (S) in an observation chamber (70) which a specimen-exchange chamber (50) having a glow-discharge digging unit (2) therein is provided adjacent to, the program **characterized by** comprising:
a first control step of controlling pressures in the specimen-exchange chamber (50) and the glow-discharge digging unit (2) to a first pressure by an exchange chamber exhausting unit (63) which exhausts air in the specimen-exchange chamber (50) and by a digging unit exhausting unit (61,62) which exhausts air in the glow-discharge digging unit (2) when the specimen (S) is transferred into the specimen-exchange chamber (50);
a second control step of controlling a pressure in the specimen-exchange chamber (50) to a second pressure which is lower than the first pressure by the exchange chamber exhausting unit (63) after the pressures are controlled to the first pressure in the first control step and the specimen (S) is digged by the glow-discharge digging unit (2); and
an output step of outputting an instruction for transferring the specimen (S) into the observation chamber (70) by the transfer means (650) after the pressure is controlled to the second pressure in the second control step.
